Europäisches Patentamt

European Patent Office

Office européen des brevets

(11) Veröffentlichungsnummer: **0 505 622 A2**

## EUROPÄISCHE PATENTANMELDUNG

(21) Anmeldenummer: **91121321.3**

(22) Anmeldetag: **12.12.91**

(51) Int. Cl.5: **G01R 31/36**

(30) Priorität: **28.03.91 DE 4110777**

(43) Veröffentlichungstag der Anmeldung:
**30.09.92 Patentblatt 92/40**

(84) Benannte Vertragsstaaten:
**AT BE CH DE DK ES FR GB IT LI NL SE**

(71) Anmelder: **ROBERT BOSCH GMBH**
**Postfach 30 02 20**
**W-7000 Stuttgart 30(DE)**

(72) Erfinder: **Hartmann, Jürgen**
**Am Hopfengarten 20**
**W-3340 Wolfenbüttel(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**W-1000 Berlin 33(DE)**

(54) **Schaltungsanordnung zum Messen und Anzeigen der verfügbaren Kapazität eines Akkumulators.**

(57) 2.1 Ist ein Akkumulator (11) in einer Kassette (10) untergebracht, die mit einem aus dem Akkumulator zu speisenden elektrischen Gerät (20) verbindbar ist, so wäre es nützlich, wenn man auf einem zu dem elektrischen Gerät gehörenden Display die augenblicklich verfügbare Kapazität des Akkumulators ablesen könnte.

2.2 Zur Lösung dieser Aufgabe wird in der Akkumulator-Kassette (10) eine elektronische Meßschaltung (12) untergebracht, die bei mit dem elektrischen Gerät (20) verbundener Akkumulator-Kassette mit einer Mikroprozessorschaltung (22) des elektrischen Gerätes verbunden ist. Die Mikroprozessorschaltung steuert die Meßschaltung (12) derart,

daß nach einem Abfragesignal ($S_S$) und einer Wartezeit ($t_W$) die Messung durchgeführt wird und daß das Meßergebnis als digitales Signal von der Meßschaltung an die Mikroprozessorschaltung weitergeleitet wird, die dafür sorgt, daß das Meßergebnis auf dem mit der Mikroprozessorschaltung verbundenen Display (24) angezeigt wird.

2.3 Eine vorteilhafte Anwendung der Schaltungsanordnung ist ein aus einer Akkumulator-Kassette gespeistes Handfunkgerät.

3. Die Zeichnung zeigt ein Blockschaltbild einer Akkumulator-Kassette und eines damit lösbar verbundenen elektrischen Gerätes.

Fig. 1

EP 0 505 622 A2

Rank Xerox (UK) Business Services

Die Erfindung geht von einer Schaltungsanordnung nach dem Oberbegriff des Anspruchs 1 aus.

Es ist eine derartige Schaltungsanordnung bekannt (Panasonic Tentative Specifications SKC 025 vom 11.6.1990), bei der durch eine elektronische Meßschaltung mittels Strom- und Zeitmessung die augenblicklich verfügbare Kapazität eines in einer Kassette untergebrachten Akkumulators gemessen wird. Der gemessene Wert wird auf einem an der Akkumulator-Kassette vorgesehenen Display angezeigt. Die bekannte Schaltungsanordnung hat den Nachteil, daß der gemessene Kapazitätswert nur auf dem Display der Akkumulator-Kassette abgelesen werden kann, während andere elektrische Funktionen eines mit der Akkumulator-Kassette verbundenen elektrischen Gerätes auf einem Display des Gerätes angezeigt werden.

Der Erfindung liegt die Aufgabe zugrunde, eine Schaltungsanordnung gemäß dem Oberbegriff des Anspruchs 1 derart weiterzubilden, daß die Anzeige der augenblicklich verfügbaren Kapazität des Akkumulators auf einem Display des elektronischen Gerätes erfolgt.

Diese Aufgabe wird bei einer Schaltungsanordnung gemäß dem Oberbegriff des Anspruchs 1 durch die im kennzeichnenden Teil dieses Anspruchs angegebenen Merkmale gelöst. Damit ist der Vorteil verbunden, daß die Anzeige der verfügbaren Akkumulator-Kapazität auf demselben Display erfolgt wie die Anzeige anderer elektrischer Funktionen oder Einstellungen des elektrischen Gerätes. Ein weiterer wesentlicher Vorteil wird erzielt, wenn zur wechselseitigen Übertragung der Datensignale zwischen elektronischer Meßschaltung und der Mikroprozessorschaltung des Gerätes nur eine zusätzliche Leitung vorgesehen ist. Dann braucht die Akkumulator-Kassette nur drei Anschlüsse aufzuweisen, nämlich einen ersten Anschluß für den Pluspol der Gleichstromversorgung, einen zweiten Anschluß für den Minuspol und einen dritten Anschluß für die wechselseitige Übertragung der Signale.

Ausführungsbeispiele der Erfindung sind in der Zeichnung an Hand mehrerer Figuren dargestellt und werden im folgenden näher beschrieben. Es zeigen

Fig. 1    ein Schaltbild der erfindungsgemäßen Schaltungsanordnung,

Fig. 2    ein Schaltbild der Meßschaltung, die durch ein Display ergänzt ist,

Fig. 3    ein Schaltbild einer Akkumulator-Kassette mit durch eine Ladeschaltung ergänzter Meßschaltung und

Fig. 4    den zeitlichen Verlauf der Datenübertragung.

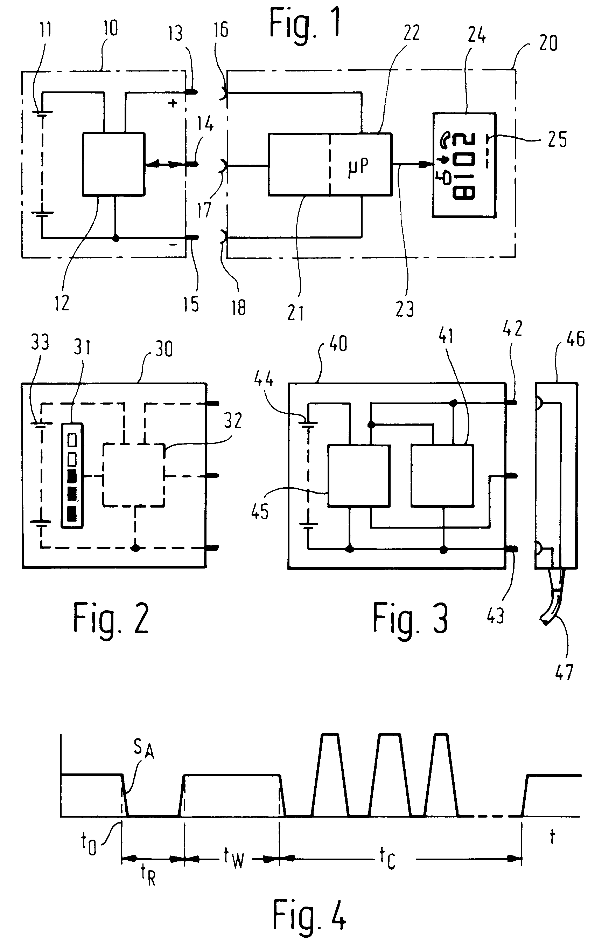

In Fig. 1 bezeichnet 10 eine Akkumulator-Kassette, die einen zum Beispiel mehrzelligen Akkumulator 11 und eine elektronische Meßschaltung 12 aufweist. Die elektronische Meßschaltung hat drei Anschlüsse 13, 14, 15, mit denen drei weitere Anschlüsse 16, 17 und 18 eines elektrischen Gerätes 20, das ist zum Beispiel ein Funkgerät, korrespondieren. Das elektrische Gerät 20 enthält eine mit den weiteren Anschlüssen 16 bis 18 verbundene Geräteschaltung 21, zu der eine Mikroprozessorschaltung 22 gehört, deren Ausgang 23 mit einem Display 24 in Verbindung steht.

Die Wirkungsweise der Schaltungsanordnung nach Fig. 1 ist folgende.

Zu Beginn wird jeder neue Akkumulator 11 einer Ladekapazitätsmessung unterzogen. Dazu wird der Akkumulator voll aufgeladen, wobei der Volladezustand durch die - $\Delta$V-Methode bestimmt wird. Sodann wird bis auf die Entladeschlußspannung entladen. Das Integral des Entladestromes über der Zeit ergibt die verfügbare Kapazität. Dieser Wert bildet die Basis für die Messung der augenblicklichen Restkapazität, indem Lade- bzw. Entladestrom über der Zeit aufintegriert werden. Auch die Zeiten ohne meßbaren Entladestrom werden mit einem typischen Wert für den Selbstentladestrom berücksichtigt.

Diese Ladekapazität kann - wie im folgenden beschrieben - durch das angeschlossene elektrische Gerät 20 über ein Anforderungssignal bei jedem Ladevorgang wiederholt werden, so daß manuell durch Tastendruck oder zeitgesteuert die Kapazitätsanzeige neu kalibriert wird. Dadurch ist auch bei durch Alterung abnehmender verfügbarer Ladekapazität eine relativ genaue Anzeige der Restkapazität der Akkumulatoren möglich.

Ist die Akkumulator-Kassette 10 mit dem elektrischen Gerät 20 mechanisch und elektrisch verbunden, so speist der angenommenerweise eine ausreichende Kapazität aufweisende Akkumulator 11 die Geräteschaltung 21 mit der Mikroprozessorschaltung 22 und dem Display 24. Zu einem Zeitpunkt $t_0$ (vgl. Fig. 4) liefert die Mikroprozessorschaltung 22 über die Anschlüsse 17 und 14 ein Anforderungssignal $S_A$ der Dauer $t_R$ an die Meßschaltung 12.

Das Anforderungssignal ist ebenso wie die im folgenden genannten Signale ein digitales Signal. Nach einer Wartezeit $t_W$ gibt die Meßschaltung an ihrem Anschluß 14 ein asynchrones serielles Kodewort der Dauer $t_C$ ab, das der gemessenen Restkapazität des Akkumulators 11 entspricht. Der gemessene Restkapazitätswert wird über die Mikroprozessorschaltung 22 auf dem Display 24 des Gerätes 20 angezeigt, vorzugsweise durch eine sogenannte Balkenanzeige 25. Das Display 24 zeigt gleichzeitig auch andere Funktionen des elektronischen Gerätes 20 an.

Das Abfragen der Akkumulator-Restkapazität kann vorzugsweise in festen, durch die Mikroprozessorschaltung 22 gesteuerten Zeitabständen automatisch erfolgen; es kann jedoch auch von Vorteil sein, die Messung nur durch die Betätigung einer bestimmten Taste des Gerätes 20 auszulösen.

Das in Fig. 2 gezeigte Schaltbild einer Akkumulator-Kassette 30 unterscheidet sich von dem Schaltbild der Akkumulator-Kassette 10 nach Fig. 1 dadurch, daß auch in der Akkumulator-Kassette ein Display 31 vorgesehen ist, das durch die Meßschaltung 32 gesteuert wird. Auf diese Weise kann die Restkapazität eines Akkumulators 33 auch dann festgestellt werden, wenn die Akkumulator-Kassette 30 von dem elektrischen Gerät 20 nach Fig. 1 getrennt aufbewahrt bzw. abgelegt wird. Das Display 31 nach Fig. 2 weist ebenfalls eine LC-Balkenanzeige auf. An die Stelle dieser Art der Anzeige kann auch eine Ziffernanzeige oder eine alphanumerische Anzeige treten. Zeigt das Display eine nur noch geringe Kapazität des Akkumulators 11 (Fig. 1) bzw. 33 (Fig. 2) an, so muß die Akkumulator-Kassette in dem Fachmann bekannter Weise in ein Ladegerät eingesteckt werden, das mit dem Wechselstromnetz verbunden ist.

Gemäß dem Schaltbild nach Fig. 3 ist in einer Akkumulator-Kassette 40 ein Ladegerät 41 integriert, das mit Anschlüssen 42 und 43 der Akkumulator-Kassette 40 und mit dem positiven und dem negativen Pol eines Akkumulators 44 in Verbindung steht. Eine derartige Akkumulator-Kassette 40 kann zum Aufladen bzw. Nachladen des Akkumulators 44 mit seinen Anschlüssen 42 und 43 an einen Adapter 46 angeschlossen werden, der über ein Kabel 47 mit dem Wechselstromnetz verbindbar ist. Der Ladezustand bzw. die augenblickliche Kapazität des Akkumulators 46 kann dann in der weiter oben beschriebenen Weise mittels einer Meßschaltung 45 gemessen und zum Beispiel mit einem in Fig. 3 nicht gezeigten Display (vgl. Display 31 in Fig. 2) angezeigt werden.

Als Meßschaltung 12, 32, 45 eignet sich eine integrierte Schaltung der Firma Panasonic mit der Bezeichnung SKC 025/035/045.

**Patentansprüche**

1. Schaltungsanordnung zum Messen und Anzeigen der verfügbaren Kapazität eines Akkumulators, der in einer Akkumulator-Kassette untergebracht ist, die mit einem aus dem Akkumulator gespeisten elektrischen Gerät lösbar verbunden ist, **dadurch gekennzeichnet**, daß die AkkumulatorKassette (10) eine mit dem Akkumulator (11) verbundene elektronische Meßschaltung (12) enthält, die mit einer Mikroprozessorschaltung (22) einer Geräteschaltung (21) verbunden ist, und daß die Mikroprozessorschaltung (22) die elektronische Meßschaltung (12) derart steuert, daß sie auf ein digitales Anforderungssignal (S_A) und nach einer Wartezeit (t_W) die Messung ausführt und ein der augenblicklichen Restkapazität des Akkumulators entsprechendes Datenwort an die Mikroprozessorschaltung abgibt und daß die Mikroprozessorschaltung ein mit dieser verbundenes Display (24) derart steuert, daß es den Restkapazitätswert des Akkumulators anzeigt.

2. Schaltungsanordnung nach Anspruch 1, dadurch gekennzeichnet, daß zur wechselseitigen Übertragung von Datensignalen zwischen der elektronischen Meßschaltung (12) und der Mikroprozessorschaltung (22) außer den mit dem Akkumulator (11) verbundenen Anschlüssen (13, 15) ein weiterer mit der Meßschaltung verbundener Anschluß (14) vorgesehen ist.

3. Schaltungsanordnung nach Anspruch 1 oder 2, dadurch gekennzeichnet, daß die Übertragung des Datensignals asynchron und seriell erfolgt.

4. Schaltungsanordnung nach einem der Ansprüche 1 bis 3, dadurch gekennzeichnet, daß die Übertragung der Datensignale als Modulation einer Trägerfrequenz erfolgt.

5. Schaltungsanordnung nach Anspruch 4, dadurch gekennzeichnet, daß die Übertragung der Datensignale als Phasenmodulation erfolgt.

6. Schaltungsanordnung nach einem der Ansprüche 1 bis 6, dadurch gekennzeichnet, daß die elektronische Meßschaltung (40) durch eine Ladeschaltung (41) zu einer Meß- und Ladeschaltung ergänzt ist, die mit dem Wechselstromnetz verbindbar ist.

7. Schaltungsanordnung nach einem der Ansprüche 1, 2 oder 6, dadurch gekennzeichnet, daß die elektronische Meßschaltung (12) eine integrierte Schaltung ist.

8. Schaltungsanordnung nach Anspruch 1 oder 2, dadurch gekennzeichnet, daß das Display (24) des elektrischen Gerätes (20) ein LC-Display (24) ist.

9. Schaltungsanordnung nach Anspruch 1, 2, oder 8, dadurch gekennzeichnet, daß das Display eine LC-Balkenanzeige (31) ist.

# Fig. 1

μP

# Fig. 2

# Fig. 3

$S_A$

$t_0$

$t_R$

$t_W$

$t_C$

$t$

# Fig. 4